# EUROPEAN PATENT SPECIFICATION

(11) **EP 0 497 982 B1**
(45) Date of publication and mention of the grant of the patent: **19.07.1995**
(21) Application number: 91913102.9
(22) Date of filing: 24.07.1991
(51) Int. Cl.: H01L 27/115

(54) **SEMICONDUCTOR DEVICE AND ITS MANUFACTURING METHOD**
HALBLEITERVORRICHTUNG UND IHR HERSTELLUNGSVERFAHREN
DISPOSITIF A SEMI-CONDUCTEUR ET SON PROCEDE DE FABRICATION

(30) Priority: 24.07.1990 JP 195864/90
(43) Date of publication of application: 12.08.1992
(73) Proprietor: RAMTRON INTERNATIONAL CORPORATION, Colorado Springs, Colorado 80921 (US)
(72) Inventor: KATO, Koji, Suwa-shi; Nagano-ken 392 (JP)
(74) Representative: Quinterno, Giuseppe
(86) International application number: JP9100989
(87) International publication number: WO9202047

(56) References cited:
- EP-A- 0 338 157
- JP-A- 0 249 471
- JP-A- 0 294 559
- JP-A- 2 183 569
- JP-A- 6 261 355

## Description

### Field of the Invention

The present invention relates to a semiconductor memory device and more particularly to an electrically rewritable non-volatile memory having a ferroelectric dielectric, and to a method for forming such a memory device.

### Background of the Invention

Semiconductor non-volatile memory devices have commonly used an MIS-type transistor which modulates a surface potential of its silicon substrate by injecting a charge from the silicon substrate into a trap or a floating gate contained in an insulating gate. Examples of such devices are EPROMs (ultraviolet erasable-type non-volatile memories), EEPROMs (electrically rewritable non-volatile memories), and the like.

However, these non-volatile memories have many performance limitations including a high write voltage (about 20 volts), a high write time (tens of msec), and limited writes (about 10,000).

A non-volatile memory utilizing an electrically polarization reversible ferroelectric, wherein write and read times are substantially the same and polarization is maintained even if the power supply source is cut off, has the possibility of exhibiting characteristics of an ideal non-volatile memory.

PAJP of/and JP-A-2-183569 disclose a ferroelectric storage device in which a gate electrode is formed over a substrate and between two diffusion regions. Over the gate electrode there is formed a layer, and a TiN electrode is located over this layer. A PZT element is then formed over the TiN electrode and a Si₃N₄ film is formed over the PZT element. Then further electrodes are formed over that.

PAJP of/and JP-A-2-94559 disclose a ferrodielectric memory device in which a thin ferrodielectric film is brought into contact with the source or drain region of a MOSFET transistor as the first electrode of a source or drain capacitor.

EP-A-338 157 discloses a DRAM memory cell also using a ferroelectric material as the dielectric between capacitor plates.

U.S. patent 4,149,302 discloses a structure integrating a capacitor consisting of a ferroelectric on a silicon substrate. U.S. patent 3,832,700 discloses a non-volatile memory arranging a ferroelectric film on the gate portion of an MIS-type transistor.

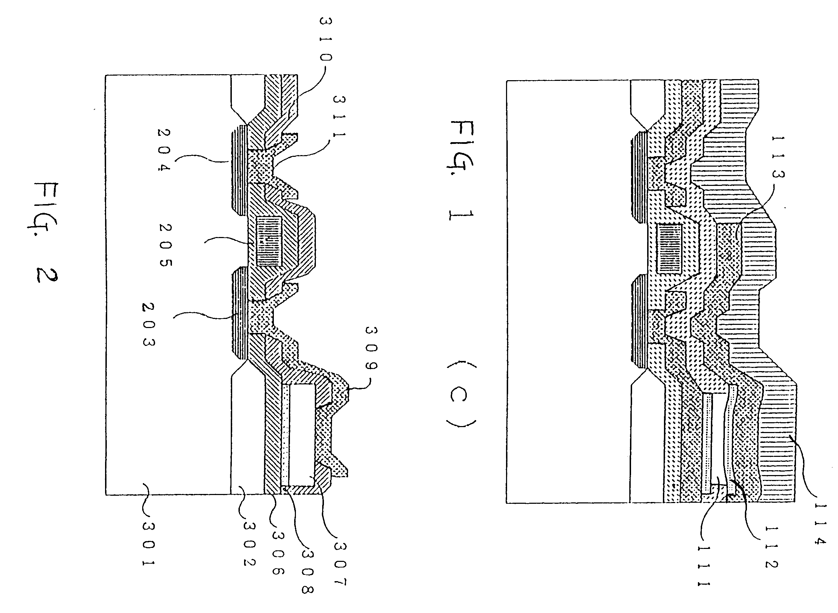

A prior art non-volatile memory having a structure laminating a ferroelectric film on an MOS-type semiconductor device is shown in application Fig. 2.

In Fig. 2, 301 denotes a P-type Si substrate, 302 denotes a LOCOS oxide film for separating elements, 203 denotes an N-type diffusion layer to be a source region, and 204 notes an N-type diffusion layer to be a drain region. 205 denotes a gate electrode, and 306 denotes an interlayer insulating film. 307 denotes a ferroelectric film, disposed between a lower electrode 308 and an upper electrode 309 to form a capacitor. 310 denotes a second interlayer insulating film, and 311 denotes an Al wire.

A structure with a ferroelectric capacitor formed on top of an interlayer insulating film that has been formed over a MOS semiconductor device creates severe topography with very high steps. This topography leads to loss of adhesion and poor aluminum step coverage. This in turn causes problems with circuit functionality and reliability.

Therefore, a general object of the present invention is to solve the above-problems. Another object of the present invention is to provide a semiconductor device having excellent reliability, particularly a non-volatile memory, by making a ferroelectric capacitor device with a more planar structure.

### Summary of the Invention

These and other objects art achieved according to the invention by the method and the semiconductor memory device whose main features are defined in Claims 1 and 7, respectively.

The present invention provides a memory device with the use of a ferroelectric film and embeds a capacitor formed with the ferroelectric film in a through-hole bored in an interlayer insulating film formed over a semiconductor substrate. This reduces the step difference caused by the capacitor, thereby improving the reliability of a wiring layer disposed thereon and increasing the reliability of a semiconductor memory.

### Brief Description of the Drawings

Fig. 1 is an essential cross section of a semiconductor device according to an embodiment of the present invention;
Fig. 2 is a cross section of a semiconductor memory device according to a prior art.

### Detailed Description of the Preferred Embodiment

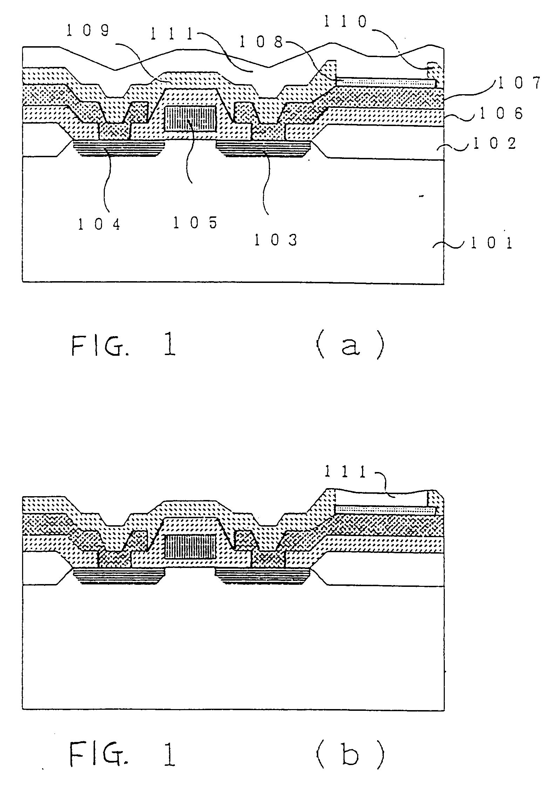

Figs. 1(a)-(c) are cross sections showing the essential step for manufacturing a semiconductor device according to a preferred embodiment of the present invention. The semiconductor device according to the present invention will be explained by referring to Figs. 1 (a)-(c).

An example of forming an N-channel transistor on an silicon substrate and using an Al layer wiring is explained with reference to Fig. 1(a). 101 denotes a preferred P-type silicon substrate having a specific resistance, for example, of about 20 Ω·cm. 102 denotes a preferred insulating film for element separation formed of an oxide film with a thickness of 6000 Å (600 nm) by a LOCOS method known in the art. 103 denotes a preferred N-type diffusion layer which will function as a source after being formed by an ion implantation of phosphorus at 80 keV to a concentration of 5x10¹⁵ cm⁻², for instance. 104 denotes a preferred N-type diffusion layer which will function as a drain region, and is simultaneously formed with source region 103. 105 denotes a preferred gate electrode using phosphorus-doped polysilicon. 106 denotes a preferred first interlayer insulating film of phosphorus glass formed to a thickness of 4000 Å (400 nm) by a preferred chemical vapor phase growth method. A contacting hole is provided by a prior art exposure technique through first interlayer insulating film 106 to the surface of source region 103. 107 denotes a preferred first wiring layer of, for example, Al formed to a 5000 Å (500 nm) thickness. 108 denotes a lower electrode preferably of Pt, Pd and the like, formed to a thickness of 1000 Å (100 nm) preferably by sputtering. 109 denotes a preferred second interlayer insulating film of phosphorus glass formed to a thickness of 5000 Å (500 nm) by a preferred chemical vapor phase growth method. A preferred through-hole 110 is formed through second interlayer insulating film 109 to the surface of lower electrode 108 by using a conventional exposure technique. 111 denotes a preferred ferroelectric film of, for example, PbTiO₃, formed to a thickness of 6000 Å (600 nm) by a bias sputtering or a chemical vapor phase growth method. The thickness of ferroelectric film 111 is preferably equal to or greater than that of second interlayer insulating film 109 (see Fig. 1(b)).

The entire surface of ferroelectric film 111 is etched back preferably by reactive or sputtering etching. For the preferred embodiment it is preferable not to have etching residue of ferroelectric film 111. It is also preferable to completely fill the through-hole 110 with ferroelectric film 111. Any etching residue of the ferroelectric film 111 will not cause a problem with the capacitor conductivity (see Fig 1(c)).

After the above procedure, an upper electrode 112 of the ferroelectric film 111 is preferably formed of Pt, Pd or the like to a thickness of 1000 Å (100 nm) by sputtering. Then a second wiring layer 113, of for example Al, is formed to a thickness of 8000 Å (800 nm) preferably by sputtering. Finally, a passivation film 114, for example SiN, is formed to a thickness of 10,000 Å (1000 nm) preferably by a chemical vapor phase growth method to obtain a semiconductor device according to a preferred embodiment of the present invention.

The use of the method steps to make the structure shown in Figs. 1 (a)-(c) results in a more planar ferroelectric capacitor device. This results in improved step coverage of the wiring layer displaced thereon and hence an improvement in the reliability of the device.

As shown in Fig. 2, a capacitor with a ferroelectric formed between a first interlayer insulating film 306 and a second interlayer insulating film 310 has a step covering ratio of the wiring layer 309, positioned above the capacitor, of about 15% as compared with the flat portion in the case of Al by sputtering. However, a capacitor with a ferroelectric embedded in a through-hole bored in a second interlayer insulating film, as in the present embodiment, has a step covering ratio of the wiring layer positioned above the capacitor improved to about 40% as compared with the flat portion in the case of Al as in the present embodiment by sputtering.

Although a non-volatile memory is explained above, the present invention can be applied to other memory devices, such as a DRAM and the like, utilizing a large specific permeability of a ferroelectric.

The present invention improves the reliability of a wiring layer passing over a capacitor and obtains a highly reliable semiconductor memory by embedding the capacitor formed with a ferroelectric film in a through-hole in an interlayer insulating film formed over a semiconductor substrate thereby reducing the step difference of the capacitor.

## Claims

1. A method for forming a semiconductor memory device comprising the steps of:
establishing a diffusion region (103) in the surface of a substrate (101);
establishing a first insulating film (102) on said substrate (101) adjacent to said diffusion region (103);
establishing a first wiring layer (107) over said first insulating film (102);
establishing a lower electrode (108) over said first wiring layer (107) and directly above said first insulating film (102);
establishing a second insulating film (109) over said first wiring layer (107) and said lower electrode (108):
establishing a through-hole (110) in said second insulating film (109) extending to said lower electrode (108);
embedding a dielectric (111), comprised of a ferroelectric material, in said through-hole (110) and over said lower electrode (108);
establishing an upper electrode (112) over said dielectric (111); and
establishing a second wiring layer (113) over said upper electrode (112).

2. The method of Claim 1 wherein said dielectric (111) is established by an isotropic film forming technique.

3. The method of Claim 2 wherein said isotropic forming technique is a bias sputtering method and chemical vapour phase growth method.

4. The method of Claim 1 further comprising the step of etching back said dielectric (111) by an anisotropic etching.

5. The method of Claim 4 wherein said anisotropic etching comprises reactive ion etching and sputtering etching.

6. The method of Claim 4 wherein said step of etching back said dielectric (111) is performed to completely fill said through-hole (110).

7. A semiconductor memory device comprising:
a substrate (101) with a diffusion region (103) at the surface of the substrate (101);
a first insulating film (102) located adjacent to said diffusion region (103);
a first wiring layer (107) located over said first insulating film (102);
a lower electrode (108) located on said first wiring layer (107) and directly above said first insulating film (102);
a second insulating film (109) located on said first wiring layer (107) and said lower electrode (108);
a through-hole (110) in said second insulating film (109) extending to said lower electrode (108) and located directly above said first insulating film (102);
a dielectric (111), comprising a ferroelectric material, embedded in said through-hole (110) and disposed directly on said lower electrode (108) and over said first insulating film (102); and
an upper electrode (112) located directly on said dielectric (111) and over said first insulating film (102).

8. The device of Claim 7, wherein said dielectric (111) has a thickness at least equal to that of said second insulating film (109).

9. The device of Claim 7 further comprising:
a further insulating film (106) disposed over said diffusion region (103) and said first insulating film (102); and
another through-hole formed in said further insulating film (106) wherein said another through-hole is disposed over and extends to said diffusion region (103) such that said first wiring layer (107) contacts said diffusion region (103) via said another through-hole.

10. The device of Claim 7, wherein said lower electrode (108) is comprised of an element selected from the group comprising Pt and Pd and has a thickness of 100 nm (1000 Å).

11. The device of Claim 7 wherein said ferroelectric material comprises PbTiO₃ and has a thickness of 600 nm (6000 Å).

12. The device of Claim 7 wherein said upper electrode (112) is comprised of an element selected from the group comprising Pt and Pd and has a thickness of 100 nm (1000 Å).

13. The device of Claim 7 further comprising a second wiring layer (113) disposed at least on said upper electrode (112).

## Patentansprüche

1. Verfahren zur Herstellung eines Halbleiterspeicherbauteils, umfassend die Schritte:
Einrichten eines Diffusionsbereichs (103) in der Oberfläche eines Substrats (101);
Einrichten eines ersten isolierenden Films (102) auf dem Substrat (101) benachbart dem Diffusionsbereich (103);
Einrichten einer ersten Verdrahtungsschicht (107) über dem ersten isolierenden Film (102),
Einrichten einer unteren Elektrode (108) über der ersten Verdrahtungsschicht (107) und direkt oberhalb des ersten isolierenden Films (102);
Einrichten eines zweiten isolierenden Films (109) über der ersten Verdrahtungsschicht (107) und der unteren Elektrode (108);
Einrichten eines Durchgangslochs (110) in dem zweiten isolierenden Film (109), welches sich zur unteren Elektrode (108) erstreckt;
Einbetten eines Dielektrikums (111), welches ein ferroelektrisches Material umfaßt, in das Durchgangsloch (110) und über der unteren Elektrode (108);
Einrichten einer oberen Elektrode (112) über dem Dielektrikum (111); und
Einrichten einer zweiten Verdrahtungsschicht (113) über der oberen Elektrode (112).

2. Verfahren nach Anspruch 1, worin das Dielektrikum (111) durch eine Technik zum Ausbilden eines isotropen Films eingerichtet wird.

3. Verfahren nach Anspruch 2, worin die Technik zum isotropen Ausbilden ein Bias-Zerstäubungs-Verfahren und ein chemisches Dampfphasen-Wachstums-Verfahren ist.

4. Verfahren nach Anspruch 1, ferner umfassend den Schritt des Zurückätzens des Dielektrikums (111) durch anisotropes Ätzen.

5. Verfahren nach Anspruch 4, worin das anisotrope Ätzen ein reaktives Ionenätzen und ein Zerstäubungsätzen umfaßt.

6. Verfahren nach Anspruch 4, worin der Schritt des Zurükkätzens des Dielektrikums (111) durchgeführt wird, um das Durchgangsloch (110) vollständig zu füllen.

7. Halbleiterspeicherbauteil, umfassend:
ein Substrat (101) mit einem Diffusionsbereich (103) an der Oberfläche des Substrats (101);
einen ersten isolierenden Film (102), welcher dem Diffusionsbereich (103) benachbart angeordnet ist;
eine erste Verdrahtungsschicht (107), welche über dem ersten isolierenden Film (102) angeordnet ist;
eine untere Elektrode (108), welche auf der ersten Verdrahtungsschicht (107) und direkt oberhalb des ersten isolierenden Films (102) angeordnet ist;
einen zweiten isolierenden Film (109), welcher auf der ersten Verdrahtungsschicht (107) und der unteren Elektrode (108) angeordnet ist;
ein Durchgangsloch (110) in dem zweiten isolierenden Film (109), welches sich zu der unteren Elektrode (108) erstreckt und direkt oberhalb des ersten isolierenden Films (102) angeordnet ist;
ein Dielektrikum (111), umfassend ein ferroelektrisches Material, welches in das Durchgangsloch (110) eingebettet ist und direkt auf der unteren Elektrode (108) und über dem ersten isolierenden Film (102) angeordnet ist; und
eine obere Elektrode (112), welche direkt auf dem Dielektrikum (111) und über dem ersten isolierenden Film (102) angeordnet ist.

8. Vorrichtung nach Anspruch 7, worin das Dielektrikum (111) eine Dicke aufweist, welche wenigstens gleich derjenigen des zweiten isolierenden Films (109) ist.

9. Vorrichtung nach Anspruch 7, ferner umfassend:
einen weiteren isolierenden Film (106), welcher über dem Diffusionsbereich (103) und dem ersten isolierenden Film (102) angeordnet ist; und
ein weiteres Durchgangsloch, welches in dem weiteren isolierenden Film (106) ausgebildet ist, worin das weitere Durchgangsloch über dem Diffusionsbereich (103) angeordnet ist und sich derart zu diesem erstreckt, daß die erste Verdrahtungsschicht (107) den Diffusionsbereich (103) über das weitere Durchgangsloch berührt.

10. Vorrichtung nach Anspruch 7, worin die untere Elektrode (108) ein Element umfaßt, welches aus der Gruppe ausgewählt ist, die Pt und Pd umfaßt, und eine Dicke von 100 nm (1000 Å) aufweist.

11. Vorrichtung nach Anspruch 7, worin das ferroelektrische Material PbTiO₃ umfaßt und eine Dicke von 600 nm (6000 Å) aufweist.

12. Vorrichtung nach Anspruch 7, worin die obere Elektrode (112) ein Element umfaßt, welches aus der Gruppe ausgewählt ist, die Pt und Pd umfaßt, und eine Dicke von 100 nm (1000 Å) aufweist.

13. Vorrichtung nach Anspruch 7, ferner umfassend eine zweite Verdrahtungsschicht (113), welche wenigstens auf der oberen Elektrode (112) angeordnet ist.

## Revendications

1. Procédé de constitution d'un dispositif de mémoire à semiconducteur, comprenant les étapes suivantes :
établissement d'une zone de diffusion (103) dans la surface d'un substrat (101) ;
application d'une première couche isolante (102) sur le susbtrat (101), de façon adjacente à la zone de diffusion (103) ;
application d'une première couche de câblage (107) sur cette première couche isolante (102) ;
établissement d'une électrode inférieure (108) sur la première couche de câblage (107) et directement au-dessus de la première couche isolante (102) ;
application d'une deuxième couche isolante (109) sur la première couche de câblage (107) et l'électrode inférieure (108) ;
établissement d'un perçage traversant (110) dans la deuxième couche isolante (109) s'étendant jusqu'à l'électrode inférieure (108) ;
enrobage d'un diélectrique (111), constitué d'un matériau ferroélectrique, à l'intérieur du perçage traversant (110) et sur l'électrode inférieure (108) ;
mise en place d'une électrode supérieure (112) sur le diélectrique (111) ; et
application d'une deuxième couche de câblage (113) sur l'électrode supérieure (112).

2. Procédé selon la revendication 1, caractérisé en ce que le diélectrique (111) est appliqué selon une technique de constitution de film isotrope.

3. Procédé selon la revendication 2, caractérisé en ce que la technique de constitution isotrope est un procédé de pulvérisation cathodique par polarisation et un procédé chimique de croissance en phase vapeur.

4. Procédé selon la revendication 1, caractérisé en ce qu'il comprend, en outre, l'opération d'attaque chimique du diélectrique (111) par attaque anisotropique.

5. Procédé selon la revendication 4, caractérisé en ce que l'attaque anisotropique comprend un procédé d'attaque au plasma et une attaque par pulvérisation cathodique.

6. Procédé selon la revendication 4, caractérisé en ce que l'opération d'attaque chimique du diélectrique (111) est réalisée afin de remplir complètement le perçage traversant (110).

7. Dispositif de mémoire à semiconducteur, comprenant :
un substrat (101) pourvu d'une zone de diffusion (103) à la surface du substrat (101) ;
une première couche isolante (102) adjacente à la zone de diffusion (103) ;
une première couche de câblage (107) disposée sur cette première couche isolante (102) ;
une électrode inférieure (108) située sur la première couche de câblage (107) et directement au-dessus de la première couche isolante (102) ;
une deuxième couche isolante (109) située sur la première couche de câblage (107) et l'électrode inférieure (108) ;
un perçage traversant (110) ménagé dans la deuxième couche isolante (109) s'étendant jusqu'à l'électrode inférieure (108) et situé directement au-dessus de la première couche isolante (102) ;
un diélectrique (111), constitué d'un matériau ferroélectrique, noyé à l'intérieur du perçage traversant (110) et disposé directement sur l'électrode inférieure (108) et par-dessus la première couche isolante (102) ; et
une électrode supérieure (112) disposée directement sur le diélectrique (111) et au-dessus de la première couche isolante (102).

8. Dispositif selon la revendication 7, caractérisé en ce que le diélectrique (111) a une épaisseur au moins égale à celle de la deuxième couche isolante (109).

9. Dispositif selon la revendication 7, caractérisé en ce qu'il comprend, en outre :
une autre couche isolante (106) disposée au-dessus de la zone de diffusion (103) et de la première couche isolante (102) ; et
un autre perçage traversant ménagé dans l'autre couche isolante (106), l'autre perçage traversant étant disposé au-dessus et s'étendant jusqu'à la zone de diffusion (103), de telle sorte que la première couche de câblage (107) soit en contact avec la zone de diffusion (103) par l'intermédiaire de cet autre perçage traversant.

10. Dispositif selon la revendication 7, caractérisé en ce que l'électrode inférieure (108) est constituée d'un élément choisi dans le groupe comprenant Pt et Pd et présente une épaisseur de 100 nm (1000 Å).

11. Dispositif selon la revendication 7, caractérisé en ce que le matériau ferroélectrique comprend du PbTiO₃ et présente une épaisseur de 600 nm (6000 Å).

12. Dispositif selon la revendication 7, caractérisé en ce que l'électrode supérieure (112) est constituée d'un élément choisi dans le groupe comprenant Pt et Pd et présente une épaisseur de 100 nm (1000 Å).

13. Dispositif selon la revendication 7, caractérisé en ce qu'il comprend, en outre, une deuxième couche de câblage (113) disposée au moins sur l'éléctrode supérieure (112).
